# EUROPEAN PATENT SPECIFICATION

(11) **EP 0 522 214 B1**
(45) Date of publication and mention of the grant of the patent: **20.03.1996**
(21) Application number: 91306350.9
(22) Date of filing: 12.07.1991
(51) Int. Cl.: H01L 31/0232, H01L 31/0216

(54) **Method of manufacturing a solid-state imaging device**
Herstellungsverfahren einer Festkörper-Bildaufnahmevorrichtung
Procédé de fabrication d'un dispositif capteur d'images à l'état solide

(30) Priority: 12.07.1990 JP 171539/90
(43) Date of publication of application: 13.01.1993
(73) Proprietor: SHARP KABUSHIKI KAISHA, Osaka 545 (JP)
(72) Inventor: Nakai, Junichi, Fukuyama-shi, Hiroshima-ken (JP); Ishibe, Shouichi, Fukuyama-shi, Hiroshima-ken (JP)
(74) Representative: Brown, Kenneth Richard

(56) References cited:
- EP-A- 0 124 025
- US-A- 4 553 153
- US-A- 4 827 118
- PATENT ABSTRACTS OF JAPAN, vol. 11, no. 33 (E-476)(2480) 30 January 1987 ; & JP-A-61 199 659
- PATENT ABSTRACTS OF JAPAN, vol. 14, no. 38 (E-878) 24 January 1990 ; & JP-A-1 270 362

## Description

### BACKGROUND OF THE INVENTION

### 1. Field of the Invention:

The present invention relates to a method of manufacturing a solid-state imaging device used in video cameras or the like and having optical component parts such as color filters, microlenses, etc. directly formed on a semiconductor substrate.

### 2. Description of the Prior Art:

In recent years, there has been an increasing need for reduction in size and enhancement of performance in the field of video cameras and other apparatus, and to meet such needs, efforts have been directed to the development of further miniaturized, higher sensitivity solid-state imaging devices which are used in such apparatus. For miniaturization and enhanced sensitivity of a solid-state imaging device, optical component parts such as color filters and microlenses are formed directly on a semiconductor substrate on which the solid-state imaging device is formed.

Formation of such optical component parts, for example, microlenses, is accomplished in the following manner. First, a transparent, non-dyeable material such as acrylic resin, epoxy resin, polyimide resin, etc. is applied by spincoating on a semiconductor substrate with a plurality of solid-state imaging devices formed thereon, thereby smoothing the surface of the semiconductor.

Thereafter, a dyeable resist for forming filters, such as gelatine, casein, etc. is applied also by spincoating, exposed to light, and developed to form a dyeable resist pattern on the pixel regions. Next, the resist pattern is dyed with a dyestuff having a desired spectral characteristic to obtain a color filter pattern. The process is repeated several times to form on-chip color filters.

On the substrate formed in this way, the same material as used for smoothing the substrate surface is applied, also by spincoating, to form a flat protective film, and on top of the protective film are formed microlenses, one for each pixel, using a known technique such as disclosed in Japanese Laid-Open Patent Publication No. 64-10666. The on-chip microlenses are thus formed.

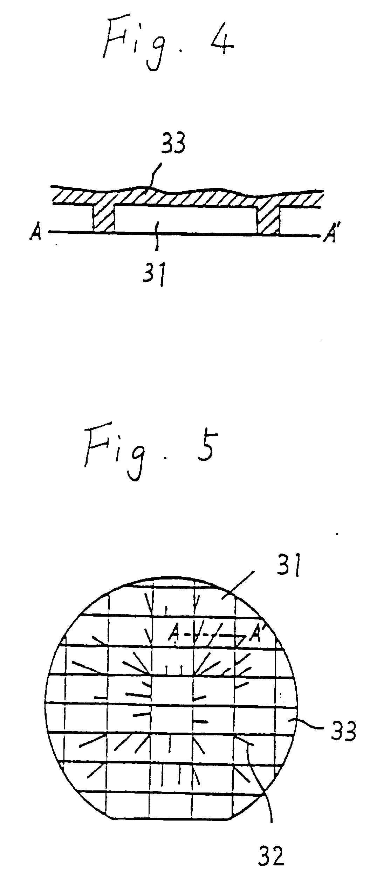

According to the above method, the non-dyeable material for smoothing the surface, the dyeable resist for forming color filters, and the resist for forming microlenses are applied on the substrate using the spincoating technique. However, since the substrate surface is uneven because of scribe lines, metal wiring, etc. formed therein, films applied by spincoating on the substrate tend to become uneven in thickness because of the irregularities on the substrate surface. For example, Figure 4 shows a case in which a color filter resist film 33 formed on a substrate 31 has an uneven thickness over the same pixel region. This appears as a thickness variation 32 on the surface of the resist film 33, as shown in Figure 5. That is, a striation appears. Figure 4 is a cross section taken along line A-A′ in figure 5.

When color filters are formed by dyeing such a resist film, the resulting problem is that imaging and sensitivity variations occur and thus the picture quality is substantially degraded, because of the thickness variations of the filter layer portions corresponding to the respective pixels.

Also, to enhance the light gathering efficiency of the microlens, it is essential that the thickness of the protective film below the microlens and the thickness of the microlens resist film be maintained uniform. However, because of the irregularities on the substrate surface, as mentioned above, it has been difficult to maintain the thicknesses of the two films uniform. Since the uneven thickness of the microlens resist film leads to uneven spacing between adjacent microlenses and variation in the bottom area thereof, there occurs variation in the light gathering efficiency among the microlenses, which causes sensitivity variations leading to degradation of the picture quality.

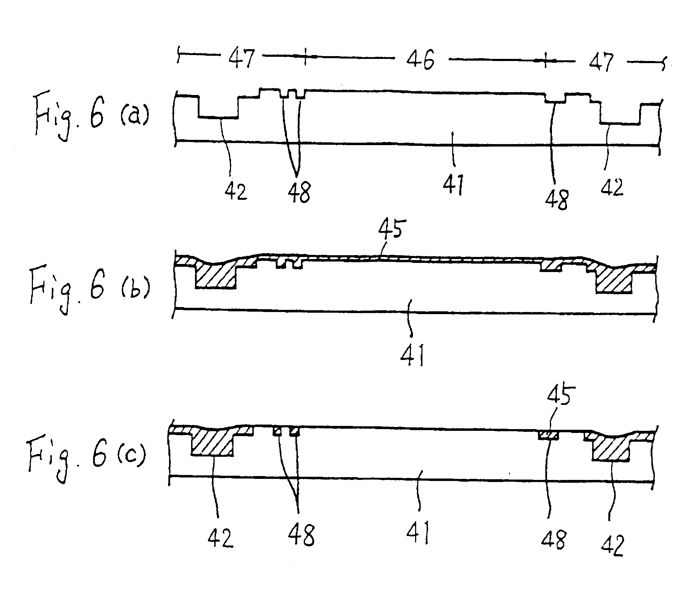

In view of the above problems, the present inventor proposed a method of manufacturing a solid-state imaging device, in which the surface of a substrate 41 shown in Figure 6(a) is coated with a polymeric material 45, as shown in Figure 6(b), the polymeric material 45 then being removed from the flat surface of a pixel region 46 but being left in recessed portions 42 and 48 formed in a peripheral region 47 surrounding the pixel region 46, thus making the surface of the substrate 41 flush on which a desired film is formed by spincoating (Japanese Patent Application No. 1(1989)-2596).

However, in the thus fabricated solid-state imaging device, since the surfaces of the polymeric material 45 embedded in the relatively large recessed portions 42 are uneven and not perfectly flat, as shown in Figure 6(c), unevenness exits in the thickness of the film formed thereon by spincoating, leading to degradation of the picture quality and thus being unable to effectively overcome the above problems.

### SUMMARY OF THE INVENTION

The method of manufacturing a solid-state imaging device of this invention, which overcomes the above-discussed disadvantages and deficiencies of the prior art, comprises the'steps of embedding a thermosoftening material containing a thermosetting agent into recessed portions in the surface of a semiconductor substrate on which a plurality of solid-state imaging devices are formed, softening the thermosoftening material embedded in the recessed portions by heating it to a temperature lower than the setting temperature of the thermosetting agent, subsequently setting the thermosoftening material by heating it to a temperature higher than the setting temperature of the thermosetting agent, forming optical component parts on the substrate, and cutting the substrate along scribe lines that constitute part of the recessed portions.

Alternatively, the method of manufacturing a solid-state imaging device, comprises the steps of embedding a thermosoftening material containing a photo-curing agent into recessed portions in the surface of a semiconductor substrate on which a plurality of solid-state imaging devices are formed, softening the thermosoftening material embedded in the recessed portions by heating, curing the thermosoftening material by radiation of light, forming optical component parts on the substrate, and cutting the substrate along scribe lines that constitute part of the recessed portions.

In a preferred embodiment, the plurality of solid-state imaging devices are each formed in a pixel region and the recessed portions are formed in a peripheral region surrounding each pixel region.

In a preferred embodiment, the optical component parts are color filters.

In a preferred embodiment, the optical component parts are microlenses.

In a preferred embodiment, the step of embedding of the polymeric material into the recessed portions is performed one or more times during the surface smoothing step.

In a preferred embodiment, a different mask pattern is used for each embedding of the polymeric material.

Thus, the invention described herein makes possible the objectives: (1) providing a method of manufacturing a solid-state imaging device in which the surface of the substrate can be more smoothed, prior to application of spincoating, by embedding the polymeric material into the recessed portions, and since films necessary for forming optical component parts are formed on the smooth substrate surface using the spincoating technique, the films can be deposited in uniform thickness, and (2) providing a solid-state imaging device with smooth substrate surface and films of uniform thickness which are required for forming optical component parts.

### BRIEF DESCRIPTION OF THE DRAWINGS

This invention may be better understood and its numerous objects and advantages will become apparent to those skilled in the art by reference to the accompanying drawings as follows:
Figure 1 is a cross sectional view of a solid-state imaging device manufactured in accordance with the present invention;
Figures 2(a) to 2(c) are cross sectional views showing the manufacturing steps for the solid-state imaging device shown in Figure 1;
Figure 3(a) is a diagram showing recessed portions of different sizes formed with different pitches, Figure 3(b) is a diagram showing the recessed portions with a polymeric material applied thereon, Figure 3(c) is a diagram showing the recessed portions after development, and Figure 3(d) is a diagram showing the recessed portions after softening of the polymeric material;
Figure 4 is a cross sectional view of a prior art solid-state imaging device with a resist film formed on a substrate;
Figure 5 is a top plan view of the surface of the resist film; and
Figures 6(a) to 6(c) are cross sectional views showing the steps of manufacturing a solid-state imaging device according to a method previously proposed by the present inventor.

### DESCRIPTION OF THE PREFERRED EMBODIMENTS

The preferred embodiments of the invention will now be described with reference to the accompanying drawings.

### Embodiment 1

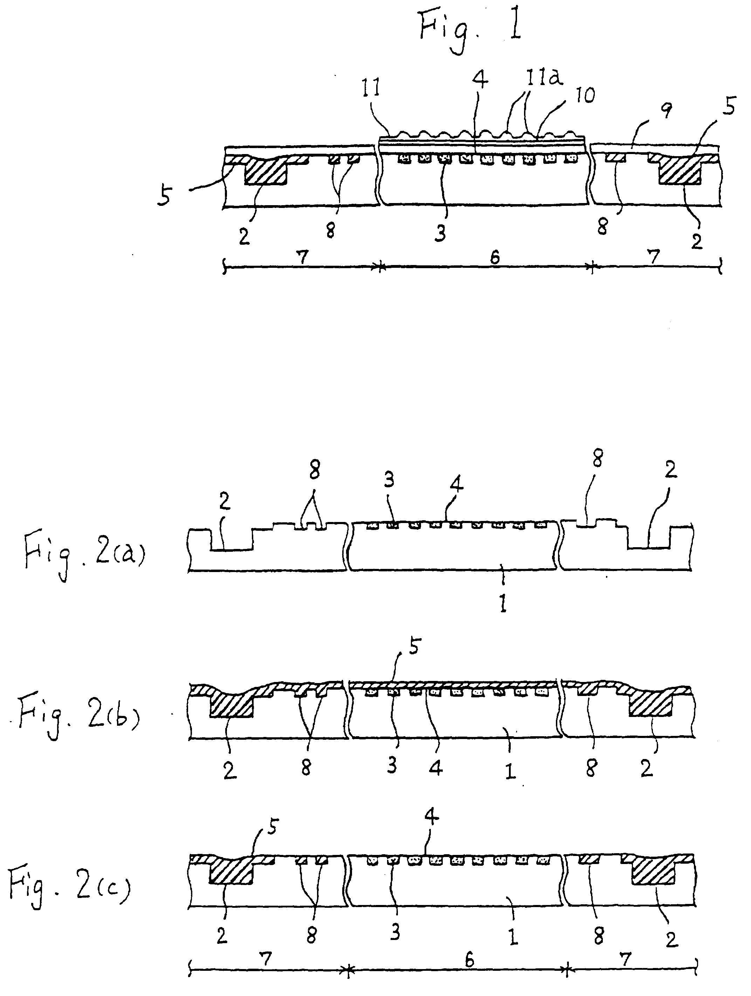

Figure 1 is a cross sectional view of a solid-state imaging device manufactured in accordance with the present invention. The solid-state imaging device comprises a pixel region 6 (actually, a plurality of such regions are formed on a semiconductor substrate I but only one such region is shown here) in which there are formed a plurality of light receiving parts 3 formed from photodiodes or the like and a plurality of transferring parts 4 formed from CCDs or the like for sequentially transferring signals photoelectric-converted by the light receiving parts 3, the pixel region 6 being surrounded by a peripheral region 7. In the peripheral region 7 there are formed recessed portions 2 that represent scribe lines and a field portion containing recessed portions 8 that are made by metal wiring, etc. The recessed portions 2 representing the scribe lines are provided to separate the pixel regions 6.

A thermosoftening resin 5 containing a thermosetting agent is embedded into the recessed portions 2 and 8 to provide a flat and flush surface. As the thermosoftening resin, polystyrene resin is used, and imide is used as the thermosetting agent. Then, a flat film 9 formed for example from a negative type transparent resin (brand name FVR-10, manufactured by Fuji Pharmaceutical Co.) is deposited covering the peripheral region 7 and the pixel region 6.

On top of the flat film 9 and above the pixel region 6, an on-chip color filter 10 and an on-chip microlens 11 are successively formed in this order. The on-chip color filter 10 is constructed, for example, with three color filter layers laid one on top of the other. One of the layers is a red color filter layer, one is a green color filter layer, the other is a blue color filter layer. The on-chip microlens 11 is formed from a transparent resin or the like, using, for example, the previously mentioned known method, the on-chip microlens 11 having convex lens portions 11a one each disposed above each light receiving part 3.

We will now describe a method of manufacturing a solid-state imaging device of the above construc-tion.

First, as shown in Figure 2(a), a semiconductor substrate 1 is readied having light receiving parts 3 and transferring parts 4 formed in each pixel region 6 and recessed portions 2 and 8 formed in each peripheral region 7, or a semiconductor substrate 1 having such configuration is fabricated. Next, as shown in Figure 2(b), the above-mentioned thermosoftening resin 5 is applied by spincoating over the entire surface of the semiconductor substrate 1. The coating is applied so that the thickness of the thermosoftening resin 5 is controlled to, for example, 1.0 µm at the portions of the substrate 1 where the recessed portions 2, 8 such as scribe lines or metal wiring are not formed.

After the coating is dried, the following processing is performed so that the thermosoftening resin 5 is left only at portions that cover the recessed portions 2 and 8 in the peripheral region 7.

By selective radiation of ultraviolet light through a mask (not shown), portions of the thermosoftening resin 5 exposed to the radiation are set. Then, the other non-set portions of the thermosoftening resin 5 are removed by using prescribed developing liquid and rinsing liquid.

As a result, the substrate 1 shown in Figure 2(c) is obtained on which the thermosoftening resin 5 is left only at portions covering the recessed portions 2 and 8. At this time, the surfaces of the portions of the thermosoftening resin 5 embedded in the recessed portions 2 and 8 are more or less rugged.

Next, the thermosoftening resin 5 is softened by heating it to a temperature lower than the setting temperature of the thermosetting agent contained therein, thereby smoothing the surfaces of the thermosoftening resin 5 embedded in the recessed portions 2 and 8, as shown in Figure 1. Thereafter, the thermosoftening resin 5 is set by heating it to a temperature higher than the setting temperature.

After that, the thermosoftening resin 5 is applied by spincoating over the entire surface of the substrate 1, to form a flat film 9. At this time, since the peripheral region 7 has a flat and flush surface as described above, the flat film 9 applied by spincoating is formed in uniform thickness free from variations of coating.

Thereafter, using a known technique, an on-chip color filter 10 and an on-chip microlens 11 are successively formed in this order on top of the pixel region 6. To form the on-chip color filter 10, a dyeable resist for forming a color filter is first applied by spincoating and is then exposed and developed to form a resist pattern, and a processing step for dyeing the resist pattern with a prescribed dye-stuff is repeated several times. The on-chip microlens 11 is formed using a known technique (such as disclosed in Japanese Laid-Open Patent Publication No. 64-10666) after forming a protective film over the on-chip color filter 10 as required.

The on-chip color filter 10 formed in this way has a uniform thickness free from thickness variation since the flat film 9 formed below it has a flat surface. For the same reason, the resist film deposited thereon to form the on-chip microlens 11 has a uniform thickness, and therefore, the lens portions 11a disposed above the light receiving parts 3 are formed equally spaced apart from each other and each having the same bottom area, thus ensuring no variation in the light gathering efficiency among them.

The substrate 1 is cut into chips along the recessed portions 2 that represent the scribe lines, thus manufacturing individual solid-state imaging devices.

Therefore, in the solid-state imaging device of the present invention, the thickness of the on-chip color filter 10 is uniform and there is no variation in the light gathering efficiency of the on-chip microlens 11, which ensures enhanced picture quality.

In the above embodiment, polystyrene resin containing imide as the thermosetting agent is used, but in this invention, thermosoftening resins such as polypropylene resin containing thermosetting agent such as epoxide may also be used for the purpose.

Also, the above embodiment has dealt with a case in which the on-chip microlens 11 is formed on top of the on-chip color filter 10, but it will be appreciated that the invention can also be applied to a case in which only the on-chip color filter or only the on-chip microlens is formed on the substrate 1 and also to a case in which other optical component parts are formed on the substrate 1.

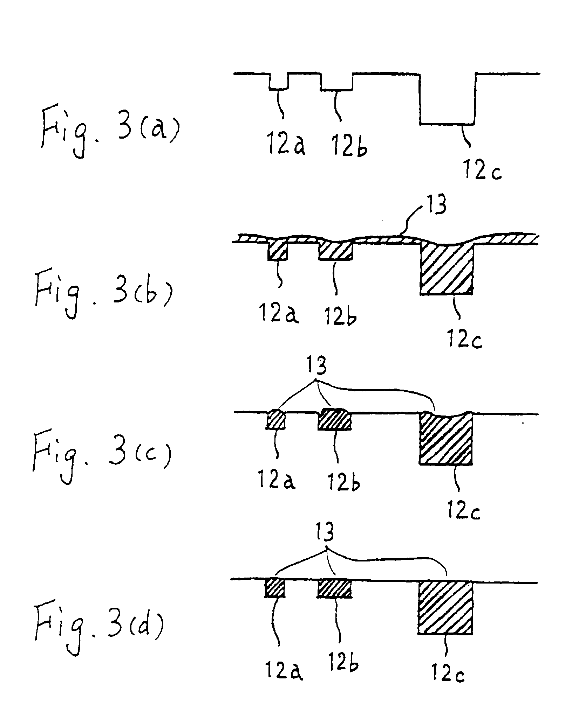

Furthermore, according to the invention, the surface flatness can be enhanced also in the case of a solid-state imaging device using a substrate having recessed portions 12a, 12b, and 12c formed in different sizes and with different pitches, as shown in Figure 3(a). When unwanted portions are removed in the previously described manner after applying a polymeric material 13 as shown in Figure 3(b), the surfaces of the portions of the polymeric material 13 left in the recessed portions 12a, 12b, and 12c are more or less rugged as shown in Figure 3(c). However, by subsequently softening the material by heating, the surfaces of the material left in the recessed portions 12a, 12b, and 12c can be made flat in a single process under the same condition, as shown in Figure 3(d), without requiring processing under different conditions according to the different sizes and pitches. The material used need not necessarily be in a polymeric state when applied for coating, but the material such as polyimide that turns into a polymer when set by heating or by radiation of light, i.e. cross-linking, may be used for the purpose.

### Embodiment 2

The invention also allows the use of a thermosoftening resin containing a photo-curing agent. In this case, the following processing is performed.

In a similar manner to that of the foregoing Embodiment 1, a thermosoftening resin such as polystyrene resin containing a photo-curing agent such as azide is applied by spincoating over the entire surface of the semiconductor substrate 1 shown in Figure 2(a). After the coating is dried, the same processing as previously described is performed so that the thermosoftening resin is left only at portions covering the recessed portions 2 and 8 in the peripheral region 7. At this time, the surfaces of the thermosoftening resin embedded in the recessed portions 2 and 8 are more or less rugged.

Next, the thermosoftening resin is softened by heating it to a temperature lower than its curing temperature, thereby smoothing the surfaces of the thermosoftening resin embedded in the recessed portions 2 and 8. Thereafter, the thermosoftening resin 5 is cured by radiation of light.

By this method also, the substrate surface can be finished flat when forming on-chip color filters and/or on-chip microlenses thereon.

In this embodiment, azide is used as the photo-curing agent, but instead, materials such as acrvlate may be used as the photo-curing agent.

## Claims

1. A method of manufacturing a solid-state imaging device, comprising the steps of:
embedding a thermosoftening material (5) containing a thermosetting agent into recessed portions (2,8) in the surface of a semiconductor substrate (1) on which a plurality of solid-state imaging devices (3,4) are formed;
softening the thermosoftening material (5) embedded in the recessed portions (2,8) by heating it to a temperature lower than the setting temperature of the thermosetting agent;
setting the thermosoftening material (5) by heating it to a temperature higher than the setting temperature;
forming optical component parts (10,11) on the substrate (1); and
cutting the substrate (1) along scribe lines (2) that constitute part of the recessed portions (2,8).

2. A method of manufacturing a solid-state imaging device as set forth in claim 1, wherein:
the plurality of solid-state imaging devices (3,4) are each formed in a pixel region (6) and the recessed portions (2,8) are formed in a peripheral region (7) surrounding each pixel region (6).

3. A method of manufacturing a solid-state imaging device as set forth in claim 1 or claim 2, wherein:
the optical component parts (10,11) include color filters (10).

4. A method of manufacturing a solid-state imaging device as set forth in any of claims 1 to 3, wherein:
the optical component parts (10,11) include microlenses (11).

5. A method of manufacturing a solid-state imaging device as set forth in any one of claims 1 to 4, wherein:
embedding of said material (5) into the recessed portions (2,8) is performed one or more times during the surface smoothing step.

6. A method of manufacturing a solid-state imaging device as set forth in claim 5, wherein:
a different mask pattern is used for each embedding of said material (5).

7. A method of manufacturing a solid-state imaging device comprising the steps of:
embedding a thermosoftening material (5) containing a photo-curing agent into recessed portions (2,8) in the surface of a semiconductor substrate (1) on which a plurality of solid-state imaging devices (3,4) are formed;
softening the thermosoftening material (5) embedded in the recessed portions (2,8) by heating;
curing the thermosoftening material (5) by radiation of light;
forming optical component parts (10,11) on the substrate (1); and
cutting the substrate (1) along scribe lines (2) that constitute part of the recessed portions (2,8).

8. A method of manufacturing a solid-state imaging device as set forth in claim 7, wherein:
the plurality of solid-state imaging devices (3,4) are each formed in a pixel region (6) and the recessed portions (2,8) are formed in a peripheral region (7) surrounding each pixel region (6).

9. A method of manufacturing a solid-state imaging device as set forth in claim 7 or claim 8, wherein:
the optical component parts (10,11) include color filters (10).

10. A method of manufacturing a solid-state imaging device as set forth in any of claims 7 to 9, wherein:
the optical component parts (10,11) include microlenses (11).

11. A method of manufacturing a solid-state imaging device as set forth in any one of claims 7 to 10, wherein:
embedding of said material (5) into the recessed portions (2,8) is performed one or more times during the surface smoothing step.

12. A method of manufacturing a solid-state imaging device as set forth in claim 11, wherein:
a different mask pattern is used for each embedding of said material (5) .

## Patentansprüche

1. Verfahren zum Herstellen einer Festkörper-Bildaufnahmevorrichtung, mit den folgenden Schritten:
- Einbetten eines bei Wärmezufuhr erweichenden Materials (5), das einen wärmehärtenden Stoff enthält, in vertiefte Bereiche (2, 8) in der Oberfläche eines Halbleitersubstrats (1), auf dem mehrere Festkörper-Bildaufnahmevorrichtungen (3, 4) ausgebildet sind;
- Erweichen des in die vertieften Bereiche (2, 8) eingebetteten, bei Wärmezufuhr erweichenden Materials (5) durch Erwärmen desselben auf eine Temperatur unter der Aushärtungstemperatur des wärmehärtenden Stoffs;
- Aushärten des bei Wärmezufuhr erweichenden Materials (5) durch Erwärmen desselben auf eine Temperatur über der Erhärtungstemperatur;
- Herstellen optischer Bauteile (10, 11) auf dem Substrat (1) und
- Zerteilen des Substrats (1) entlang Ritzlinien (2), die Teil der vertieften Bereiche (2, 8) sind.

2. Verfahren zum Herstellen einer Festkörper-Bildaufnahmevorrichtung nach Anspruch 1, bei dem die mehreren Festkörper-Bildaufnahmevorrichtungen (3, 4) jeweils in einem Pixelbereich (6) ausgebildet sind und die vertieften Bereiche (2, 8) in einem jeden Pixelbereich (6) umgebenden Umfangsbereich (7) ausgebildet sind.

3. Verfahren zum Herstellen einer Festkörper-Bildaufnahmevorrichtung nach Anspruch 1 oder Anspruch 2, bei dem zu den optischen Bauteilen (10, 11) Farbfilter (10) gehören.

4. Verfahren zum Herstellen einer Festkörper-Bildaufnahmevorrichtung nach einem der Ansprüche 1 bis 3, bei dem zu den optischen Bauteilen (10, 11) Mikrolinsen (11) gehören.

5. Verfahren zum Herstellen einer Festkörper-Bildaufnahmevorrichtung nach einem der Ansprüche 1 bis 4, bei dem das Einbetten des Materials (5) in die vertieften Bereiche (2, 8) während des Schritts zum Glätten der Oberfläche einmal oder mehrmals ausgeführt wird.

6. Verfahren zum Herstellen einer Festkörper-Bildaufnahmevorrichtung nach Anspruch 5, bei dem für jedes Einbetten des Materials (5) ein anderes Maskenmuster verwendet wird.

7. Verfahren zum Herstellen einer Festkörper-Bildaufnahmevorrichtung, mit den folgenden Schritten:
- Einbetten eines bei Wärmezufuhr erweichenden Materials (5), das einen lichthärtenden stoff enthält, in vertiefte Bereiche (2, 8) in der Oberfläche eines Halbleitersubstrats (1), auf dem mehrere Festkörper-Bildaufnahmevorrichtungen (3, 4) ausgebildet sind;
- Erweichen des in die vertieften Bereiche (2, 8) eingebetteten, bei Wärmezufuhr erweichenden Materials (5) durch Erwärmen;
- Aushärten des bei Wärmezufuhr erweichenden Materials (5) durch Einstrahlen von Licht;
- Herstellen optischer Bauteile (10, 11) auf dem Substrat (1) und
- Zerteilen des Substrats (1) entlang Ritzlinien (2), die Teil der vertieften Bereiche (2, 8) bilden.

8. Verfahren zum Herstellen einer Festkörper-Bildaufnahmevorrichtung nach Anspruch 7, bei dem die mehreren Festkörper-Bildaufnahmevorrichtungen (3, 4) jeweils in einem Pixelbereich (6) ausgebildet sind und die vertieften Bereiche (2, 8) in einem jeden Pixelbereich (6) umgebenden Umfangsbereich (7) ausgebildet sind.

9. Verfahren zum Herstellen einer Festkörper-Bildaufnahmevorrichtung nach Anspruch 7 oder Anspruch 8, bei dem zu den optischen Bauteilen (10, 11) Farbfilter (10) gehören.

10. Verfahren zum Herstellen einer Festkörper-Bildaufnahmevorrichtung nach einem der Ansprüche 7 bis 9, bei dem zu den optischen Bauteilen (10, 11) Mikrolinsen (11) gehören.

11. Verfahren zum Herstellen einer Festkörper-Bildaufnahmevorrichtung nach einem der Ansprüche 7 bis 10, bei dem das Einbetten des Materials (5) in die vertieften Bereiche (2, 8) während des Schritts zum Glätten der Oberfläche einmal oder mehrmals ausgeführt wird.

12. Verfahren zum Herstellen einer Festkörper-Bildaufnahmevorrichtung nach Anspruch 11, bei dem für jedes Einbetten des Materials (5) ein anderes Maskenmuster verwendet wird.

## Revendications

1. Procédé de fabrication d'un dispositif capteur d'images à état solide comprenant les stades suivants :
on remplit d'une matière thermoramollissable (5) contenant un agent thermodurcissable des parties évidées (2, 8) de la surface du substrat semi-conducteur (1) sur laquelle une série de dispositifs capteurs d'image à état solide (3, 4) sont formés,
on ramollit la matière thermoramollissable (5) introduite dans les parties évidées (2, 8) en la chauffant à une température inférieure à la température de durcissement de l'agent thermodurcissable,
on durcit la matière thermoramollissable (5) en la chauffant à une température supérieure à la température de durcissement de l'agent thermodurcissable,
on forme des composants optiques (10, 11) sur le substrat (1), et
on découpe le substrat (1) le long de lignes de tranchage (2) qui constituent une partie des parties évidées (2, 8).

2. Procédé de fabrication d'un dispositif capteur d'images à état solide selon la revendication 1, dans lequel :
la série de dispositifs capteurs d'images à état solide (3, 4) sont formés chacun dans une région de pixels (6) et les parties évidées (2, 8) sont formées dans une région périphérique (7) entourant chaque région de pixels (6).

3. Procédé de fabrication d'un dispositif capteur d'images à état solide selon la revendication 1 ou 2, dans lequel :
les composants optiques (10, 11) sont des filtres de couleurs (10).

4. Procédé de fabrication d'un dispositif capteur d'images à état solide selon l'une quelconque des revendications 1 à 3, dans lequel :
les composants optiques (10, 11) sont des microlentilles (11).

5. Procédé de fabrication d'un dispositif capteur d'images à état solide selon l'une quelconque des revendications 1 à 4, dans lequel :
le stade d'introduction de ladite matière polymère (5) dans les parties évidées (2, 8) est réalisé à une ou plusieurs reprises au cours du stade d'égalisation de la surface.

6. Procédé de fabrication d'un dispositif capteur d'images à état solide selon la revendication 5, dans lequel :
un motif de masquage différent est utilisé pour chaque introduction de ladite matière (5).

7. Procédé de fabrication d'un dispositif capteur d'images à état solide comprenant les stades suivants :
on remplit d'une matière thermoramollissable (5) contenant un agent photodurcissant des parties évidées (2, 8) de la surface d'un substrat semi-conducteur sur laquelle une série de dispositifs capteurs d'images à état solide (3, 4) sont formés,
on ramollit la matière thermoramollissable (5) introduite dans les parties évidées (2, 8) par chauffage,
on durcit la matière thermoramollissable (5) par un rayonnement de lumière,
on forme des composants optiques (10, 11) sur le substrat, et
on découpe le substrat (1) le long de lignes de tranchage (2) qui constituent une partie des parties évidées (2, 8).

8. Procédé de fabrication d'un dispositif capteur d'images à état solide selon la revendication 7, dans lequel :
la série de dispositifs capteurs d'images à état solide (2, 4) sont formés chacun dans une région de pixels (6) et les parties évidées (2, 8) sont formées dans une région périphérique (7) entourant chaque région de pixels (6).

9. Procédé de fabrication d'un dispositif capteur d'images à état solide selon la revendication 7 ou 8, dans lequel :
les composants optiques (10, 11) sont des filtres de couleurs (10).

10. Procédé de fabrication d'un dispositif capteur d'images à état solide selon l'une quelconque des revendications 7 à 9, dans lequel :
les composants optiques (10, 11) sont des microlentilles (11).

11. Procédé de fabrication d'un dispositif capteur d'images à état solide selon l'une quelconque des revendications 7 à 10, dans lequel :
le stade d'introduction de ladite matière polymère (5) dans les parties évidées (2, 8) est réalisé à une ou plusieurs reprises au cours du stade d'égalisation de la surface.

12. Procédé de fabrication d'un dispositif capteur d'images à état solide selon la revendication 11, dans lequel :
un motif de masquage différent est utilisé pour chaque introduction de ladite matière (5).
